# FASCICULE DE BREVET EUROPEEN

(11) **EP 1 476 898 B1**
(45) Date de publication et mention de la délivrance du brevet: **28.12.2005**
(21) Numéro de dépôt: 03718870.3
(22) Date de dépôt: 13.02.2003
(51) Int. Cl.: H01L 21/20, C30B 25/18, C30B 29/36, C30B 29/40

(54) **PROCEDE DE FORMATION DE COUCHE DE CARBURE DE SILICIUM OU DE NITRURE D ELEMENT III SUR UN SUBSTRAT ADAPTE**
VERFAHREN ZUR HERSTELLUNG EINER SCHICHT AUS SILIZIUM KARBID ODER AUS EINER GRUPPE III-NITRID AUF EIN ANGEPASSTES SUBSTRAT
METHOD FOR PRODUCTION OF A LAYER OF SILICON CARBIDE OR A NITRIDE OF A GROUP III ELEMENT ON A SUITABLE SUBSTRATE

(30) Priorité: 15.02.2002 FR 0201941
(43) Date de publication de la demande: 17.11.2004
(73) Titulaire: CENTRE NATIONAL DE LA RECHERCHE SCIENTIFIQUE (CNRS), 75794 Paris Cedex 16 (FR)
(72) Inventeur: LEYCURAS, André, F-06560 Valbonne (FR)
(74) Mandataire: de Beaumont, Michel
(86) Numéro de dépôt international: PCT/FR2003/000474
(87) Numéro de publication internationale: WO 2003/069657

(56) Documents cités:
- EP-A- 0 514 018
- WO-A-00/31317
- WO-A-01/22482
- WO-A-98/00857
- YONENAGA I: "Czochralski growth of GeSi bulk alloy crystals" JOURNAL OF CRYSTAL GROWTH, NORTH-HOLLAND PUBLISHING CO. AMSTERDAM, NL, vol. 198-199, mars 1999 (1999-03), pages 404-408, XP004170887 ISSN: 0022-0248
- PATENT ABSTRACTS OF JAPAN vol. 1998, no. 01, 30 janvier 1998 (1998-01-30) & JP 09 249499 A (MATSUSHITA ELECTRON CORP;SUGINO TAKASHI), 22 septembre 1997 (1997-09-22)
- PATENT ABSTRACTS OF JAPAN vol. 2002, no. 04, 4 août 2002 (2002-08-04) & JP 2001 335934 A (JAPAN ATOM ENERGY RES INST), 7 décembre 2001 (2001-12-07)

## Description

La présente invention concerne la réalisation de composants optiques, électroniques ou optoélectroniques.

Il est connu que des composants optoélectroniques tels que des lasers, des diodes électroluminescentes et des détecteurs optiques, notamment dans l'ultraviolet, peuvent avantageusement être formés dans des couches cristallines de nitrures d'éléments du groupe III, tels que le nitrure d'aluminium AIN, le nitrure de gallium GaN, le nitrure d'indium InN..., cubiques ou hexagonaux.

Les nitrures d'éléments du groupe III peuvent en particulier être déposés sur des cristaux ou des couches cristallisées de carbure de silicium (SiC).

On est arrivé à fabriquer des variétés hexagonales de carbure de silicium par des méthodes de croissance par sublimation ou par dépôt chimique en phase vapeur à très haute température (2300°C). Toutefois, ces températures très élevées et la grande susceptibilité de la qualité des cristaux aux divers gradients thermiques font qu'ils sont extrêmement chers et qu'il est difficile et coûteux d'obtenir des cristaux d'une taille suffisante.

Par ailleurs, on a tenté de faire croître des couches de carbure de silicium cubique par dépôt chimique en phase vapeur sur divers substrats. En effet, contrairement aux variétés hexagonales pour lesquelles on dispose de germes mono-cristallins de dimensions centimétriques mais de très bonne qualité (obtenus spontanément lors de la fabrication de carbure de silicium à usage abrasif) pour initier les premières croissances, on ne connaît pas de substrat au paramètre de maille du carbure de silicium cubique. Le même problème se pose pour les nitrures d'éléments III qu'ils soient cubiques ou hexagonaux.

Les tentatives les plus poussées de dépôt de couche de carbure de silicium cubique ont été réalisées sur des substrats de silicium monocristallin. En effet, il existe un rapport de maille sensiblement égal à 5/4 entre le carbure de silicium cubique et un cristal de silicium. Toutefois, étant donné que les épitaxies de carbure de silicium se font à des températures pouvant atteindre 1350°C et qu'il existe un écart de coefficient de dilation important entre la couche de carbure de silicium et le substrat, il apparaît lors du refroidissement de très fortes contraintes.

Ces contraintes dépendent de l'épaisseur de la couche, de celle du substrat et des constantes élastiques des deux. Les valeurs d'épaisseur de couches de carbure de silicium sont données à titre d'exemple dans tout le texte dans le cas d'un substrat de 300 µm d'épaisseur et de 50mm de diamètre.

Par exemple, si une couche de 2 µm de SiC cubique a été formée sur un substrat de silicium orienté selon le plan (111), on observe après refroidissement une courbure du substrat présentant une flèche de l'ordre de 0,5 mm. Ce phénomène s'accentue si l'on cherche à obtenir une couche de carbure de silicium plus épaisse et ceci conduit souvent à des ruptures ou craquelures de la couche et donc à une très mauvaise qualité finale de la couche de carbure de silicium. En outre, même s'il ne se produit pas de rupture, la courbure importante obtenue empêche de réaliser convenablement les opérations photolithographiques nécessaires dans la plupart des applications de ces couches à la réalisation de composants optoélectroniques.

Diverses tentatives ont été faites pour améliorer cet état de chose, en particulier en utilisant des substrats de type silicium sur oxyde mais ceci n'a pas conduit non plus à des résultats satisfaisants. Dans le cas d'une croissance de Sic sur substrat de silicium d'épaisseur 300 µm orienté (100), il est possible d'atteindre une épaisseur de 10 µm ou plus avec une courbure mais sans craquelures. Cela permet d'employer la méthode du brevet PCT WO0031317 du CNRS dont l'inventeur est André Leycuras et qui consiste à convertir le silicium du substrat en carbure de silicium, ce qui élimine les contraintes.

La présente invention a pour objet de prévoir la formation d'une couche de carbure de silicium sur un substrat permettant d'obtenir cette couche avec une qualité cristalline suffisante sans fortes contraintes mécaniques.

Un autre objet de la présente invention est de prévoir la formation d'une telle couche de carbure de silicium adaptée à un dépôt ultérieur d'un nitrure d'un élément du groupe III.

Un autre objet de la présente invention est de prévoir la formation d'une couche de nitrure d'un élément du groupe III sur un substrat permettant d'obtenir cette couche avec une qualité cristalline suffisante et ne présentant pas de forte contrainte mécanique.

Pour atteindre ces objets, la présente invention prévoit d'utiliser comme substrat un substrat monocristallin d'alliage silicium-germanium, Si₁₋ₓGeₓ, la proportion de germanium, x, étant comprise dans une plage de 5 à 90%, 5 à 20% pour le carbure de silicium, et 10 à 90% pour les nitrures.

Si la proportion de germanium est proche de 7% d'atomes de germanium pour 92,5% d'atomes de silicium, la condition d'un rapport de cinq mailles de carbure de silicium pour quatre mailles de silicium-germanium est satisfaite de façon sensiblement parfaite, c'est-à-dire que l'on pourra obtenir une excellente croissance monocristalline du carbure de silicium sur le silicium-germanium. Toutefois, il existe alors un léger désaccord de coefficient de dilatation et l'on obtient une légère courbure de la structure résultante après refroidissement. Cette courbure reste tout à fait acceptable et ne provoque pas de défaut notable quand la couche de carbure de silicium est relativement mince, par exemple d'une épaisseur inférieure à 5 µm et de préférence de l'ordre de 2 à 3 µm si l'orientation du substrat est dans un plan (111) et jusqu'à 20 µm dans le cas d'une orientation (100).

Si la proportion de germanium est proche de 16% d'atomes de germanium pour 84% d'atomes de silicium, on obtient des variations de coefficient de dilatation sensiblement identiques entre des températures de l'ordre de 1350°C et la température ambiante pour le carbure de silicium et le silicium-germanium. On préférera donc se rapprocher de cette proportion quand on veut faire croître des couches de carbure de silicium relativement épaisses par exemple d'une épaisseur de l'ordre de 20 µm quelle que soit l'orientation du substrat de silicium-germanium. On notera que, dans ce cas, le rapport de 4 à 5 entre les mailles n'est pas parfaitement satisfait mais cela est moins important car, étant donné la nature cubique du carbure de silicium obtenu, la qualité cristalline s'améliore quand l'épaisseur de la couche de carbure de silicium obtenue par croissance augmente du fait de la probabilité assez grande que les défauts cristallins étendus (dislocations et fautes d'empilement) qui ne sont pas parallèles à la direction de croissance , s'annihilent lorsqu'ils se croisent. On observe ainsi une densité de défauts beaucoup plus faible à la surface de la couche qu'à son interface avec le substrat dans le cas des cristaux cubiques.

Ce qui vient d'être exposé pour le carbure de silicium s'applique également pour la croissance directe d'une couche de nitrure d'un élément du groupe III sur un substrat de silicium-germanium. La composition du substrat sera alors adaptée pour optimiser l'accord des coefficients de dilatation ou la relation de 5 mailles de nitrure pour 4 mailles de SiGe. Par exemple, pour GaN, l'accord des coefficients de dilatation est optimal pour une proportion atomique de 13% de Ge et de 87% de Si. Toutefois, on préférera souvent faire croître un nitrure d'un élément de groupe III sur une couche de carbure de silicium cubique. L'orientation (111) du substrat sera favorable à la croissance de la forme hexagonale de la couche de nitrure alors que l'orientation (100) sera favorable à la croissance de la forme cubique de la couche de nitrure. La contrainte de la couche étant pratiquement nulle, il est possible de déposer une couche très épaisse quelle que soit l'orientation du substrat sans que celle-ci présente de craquelures. Pour une relation épitaxiale 5/4 il faut une composition voisine 86% d'atomes de germanium ou comprise entre 80 et 90%. L'accord des coefficients de dilatation de la couche et du substrat n'est pas respecté mais dans la mesure où la couche se trouvera en légère compression à la température ambiante, cette composition peut être intéressante.

Une application directe des procédés connus de croissance d'une couche de carbure de silicium sur du silicium ne permet pas de fournir des couches de carbure de silicium satisfaisantes sur un substrat de silicium-germanium. Notamment, on pouvait penser que des problèmes graves pouvaient se poser du fait que le germanium fond à une température de l'ordre de 941°C, et surtout parce qu'il n'existe pas de carbure de germanium ce qui pouvait risquer d'empêcher la formation d'une couche continue et monocristalline de SiC sur toute la surface du substrat. Ainsi, si on applique pour une croissance sur silicium-germanium les procédés connus pour une croissance sur silicium, et notamment si l'on utilise des conditions de carburation initiales connues, on obtient une couche de carbure de silicium fortement polycristalline, et il se forme éventuellement une ségrégation du germanium en surface qui peut perturber la croissance de la couche de Sic.

Ainsi, la présente invention, selon l'un de ses aspects, prévoit la formation initiale sur une première face d'un substrat de silicium-germanium d'une couche très mince de l'ordre de 2 à 10 nm de SiC par carburation en procédant à une élévation régulière de température de l'ordre de 10°C par seconde entre 800°C et seulement 1150°C. Le gaz de carburation, choisi parmi les gaz de carburation usuels, est de préférence du propane, en présence d'hydrogène. On s'aperçoit alors que la couche obtenue a une structure satisfaisante alors que, si l'on avait procédé à une croissance dans une telle plage de températures sur du silicium, le dépôt ne se serait pas effectué de manière monocristalline. En effet, sur silicium pour obtenir des dépôts de carbure de silicium satisfaisants, il faut monter jusqu'à une température de l'ordre de 1200°C. Les valeurs de température ci-dessus sont données à titre d'exemple dans le cas du réacteur réalisé selon la demande de brevet PCT/FR 99 02909 dont l'inventeur est André Leycuras. Dans d'autres réacteurs les valeurs peuvent être sensiblement différentes en raison notamment d'un environnement thermique différent du substrat. Il demeure néanmoins que, dans un réacteur donné, la carburation de l'alliage silicium-germanium s'effectue à une température nettement inférieure à celle qui devrait être utilisée pour du silicium.

Une autre approche pour s'affranchir du problème éventuellement posé par la présence du germanium consiste à épitaxier ou à transférer une couche mince de silicium, d'une épaisseur de 10 à 50 nm, sur le substrat de germanium-silicium de manière à pouvoir revenir aux conditions connues de croissance du carbure de silicium sur silicium.

Dans une phase suivante, on procède à une croissance épitaxiale de SiC par dépôt chimique en phase vapeur puis éventuellement à un épaississement de la couche par un procédé de conversion en phase liquide du silicium du substrat en carbure de silicium, comme cela est décrit par exemple dans le brevet PCT du CNRS WO003117 dont l'inventeur est André Leycuras. Cette deuxième croissance permet d'atteindre les épaisseurs de SiC pouvant aller jusqu'à et au-delà de 20 *µ*m.

Comme on l'a indiqué précédemment, on pourra aussi faire croître des nitrures d'éléments III directement sur du silicium-germanium. Avec une croissance d'une couche d'AlN ou de GaAIN sur un substrat SiGe de composition convenable, on peut faire croître des couches jusqu'à 10 µm d'épaisseur et plus sans contrainte et donc sans déformation. Il est toujours intéressant d'introduire un super réseau AlN/GaN ou AlGaN pour filtrer les dislocations en tenant compte de l'expansion thermique de la structure totale pour déterminer la composition du substrat SiGe qui aura la même expansion afin d'annuler toute contrainte thermique.

Sur une couche de carbure ou de nitrure obtenue selon l'invention, une technique dite de croissance latérale peut être appliquée avantageusement à la croissance de couches de carbure de silicium cubique ou de couches de nitrures d'éléments du groupe III notamment dans les variantes particulièrement intéressantes faisant appel à la gravure du substrat. Cette opération est beaucoup plus facile dans le cas de l'alliage silicium-germanium que dans le cas d'une croissance sur substrat de silicium. Par ailleurs l'absence de contraintes dans les couches permet de répéter plusieurs fois les opérations de manière à éliminer au maximum les zones présentant des défauts.

Selon un mode de réalisation de la présente invention, la couche de carbure de silicium a une épaisseur de l'ordre de 2 à 3 µm, et le germanium est dans une proportion atomique voisine de 7,5%, comprise entre 5 et 10%.

Selon un mode de réalisation de la présente invention, la couche de carbure de silicium a une épaisseur de l'ordre de 5 à 20 µm, et le germanium est dans une proportion atomique voisine de 16%, comprise entre 14 et 18%.

Selon un mode de réalisation de la présente invention, la couche de nitrure a une épaisseur de l'ordre de 1 à 5 µm, et le germanium est dans une proportion atomique voisine de 85%, comprise entre 80 et 90%.

Selon un mode de réalisation de la présente invention, la couche de nitrure a une épaisseur de l'ordre de 5 à 20 *µ*m, et le germanium est dans une proportion atomique voisine de 13%, comprise entre 10 et 15%.

Selon un mode de réalisation de la présente invention, la formation de la couche de carbure de silicium comprend une première étape consistant à réaliser une carburation de la surface du substrat en présence d'un gaz de carburation choisi dans le groupe comprenant le propane et l'éthylène, et en présence d'hydrogène, à une température inférieure à 1150°C et une deuxième étape de croissance par dépôt chimique en phase vapeur .

Selon un mode de réalisation de la présente invention, la formation de la couche de carbure de silicium comprend en outre une étape de croissance d'une couche de silicium d'une épaisseur de 10 à 50 µm avant l'étape de carburation.

## Revendications

1. Produit intermédiaire pour la réalisation de composants optiques, électroniques ou optoélectroniques, comprenant une couche cristalline de carbure de silicium cubique sur un substrat monocristallin, **caractérisé en ce que** le substrat est du silicium-germanium, le germanium étant dans une proportion atomique comprise entre 5 et 20%.

2. Produit selon la revendication 1, dans lequel la couche de carbure de silicium a une épaisseur de l'ordre de 2 à 3 µm, et dans lequel le germanium est dans une proportion atomique voisine de 7,5%, comprise entre 5 et 10%.

3. Produit selon la revendication 1, dans lequel la couche de carbure de silicium a une épaisseur de l'ordre de 5 à 20 µm, et dans lequel le germanium est dans une proportion atomique voisine de 16%, comprise entre 14 et 18%.

4. Produit selon la revendication 1 ou 2, dans lequel la couche de carbure de silicium est revêtue d'une couche cristalline d'un nitrure d'un élément du groupe III.

5. Produit intermédiaire pour la réalisation de composants optiques, électroniques ou optoélectroniques, **caractérisé en ce qu'**il comprend une couche cristalline d'un nitrure d'un élément du groupe III tel que AlN, InN, GaN sur un substrat monocristallin de silicium-germanium orienté (111), le germanium étant dans une proportion atomique comprise entre 10 et 90%.

6. Produit selon la revendication 5, dans lequel la couche de nitrure a une épaisseur de l'ordre de 1 à 5 µm, et dans lequel le germanium est dans une proportion atomique voisine de 85%, comprise entre 80 et 90%.

7. Produit selon la revendication 5, dans lequel la couche de nitrure a une épaisseur de l'ordre de 5 à 20 µm, et dans lequel le germanium est dans une proportion atomique voisine de 13%, comprise entre 10 et 15%.

8. Procédé de formation d'une couche cristalline de carbure de silicium cubique, **caractérisé en ce qu'**il consiste à faire croître par épitaxie ladite couche sur un substrat monocristallin de silicium-germanium, le germanium étant dans une proportion atomique comprise entre 5 et 20%.

9. Procédé selon la revendication 8, dans lequel la formation de la couche de carbure de silicium comprend une première étape consistant à réaliser une carburation de la surface du substrat en présence d'un gaz de carburation choisi dans le groupe comprenant le propane et l'éthylène, et en présence d'hydrogène, à une température inférieure à 1150°C et une deuxième étape de croissance par dépôt chimique en phase vapeur.

10. Procédé selon la revendication 9, comprenant en outre une étape de croissance d'une couche de silicium d'une épaisseur de 10 à 50 µm avant l'étape de carburation.

11. Procédé selon la revendication 9, comprenant en outre une étape de conversion en phase liquide du silicium en carbure de silicium.

12. Procédé selon la revendication 8, consistant en outre à réaliser la croissance d'une couche d'un nitrure d'un élément du groupe III sur la couche de carbure de silicium.

13. Procédé de formation d'une couche cristalline d'un nitrure d'un élément du groupe III, **caractérisé en ce qu'**il consiste à faire croître ladite couche sur un substrat monocristallin de silicium-germanium, le germanium étant dans une proportion atomique comprise entre 10 et 90%.

## Patentansprüche

1. Zwischenerzeugnis für die Herstellung von optischen, elektronischen oder optoelektronischen Komponenten, mit einer kristallinen Schicht aus kubischem Siliziumkarbid auf einem monokristallinen Substrat, **dadurch gekennzeichnet, dass** das Substrat Silizium-Germanium ist, wobei das Germanium in einem atomaren Anteil zwischen 5 und 20 % vorliegt.

2. Zwischenerzeugnis nach Anspruch 1, wobei die Schicht aus Siliziumkarbid eine Dicke in der Größenordnung von 2 bis 3 µm aufweist und wobei das Germanium in einem atomaren Anteil zwischen 5 und 10 % in der Nähe von 7,5 % vorliegt.

3. Erzeugnis nach Anspruch 1, wobei die Schicht aus Siliziumkarbid eine Dicke in der Größenordnung von 5 bis 20 µm aufweist und das Germanium in einem atomaren Anteil zwischen 14 und 18 % in der Nähe von 16 % vorliegt.

4. Erzeugnis nach Anspruch 1 oder 2, wobei die Schicht aus Siliziumkarbid von einer kristallinen Schicht eines Nitrides eines Elementes der Gruppe III bedeckt ist.

5. Zwischenerzeugnis zur Herstellung von optischen, elektronischen oder optoelektronischen Komponenten, **dadurch gekennzeichnet, dass** es eine kristalline Schicht eines Nitrides eines Elementes der Gruppe III, zum Beispiel AlN, InN, GaN, auf einem monokristallinen orientierten (111) Silizium-Germanium aufweist, wobei das Germanium in einem atomaren Anteil zwischen 10 und 90 % vorliegt.

6. Erzeugnis nach Anspruch 5, wobei die Nitridschicht eine Dicke im Bereich von 1 bis 5 µm aufweist, und wobei das Germanium in einem atomaren Anteil zwischen 80 und 90 % in der Nähe von 85 % vorliegt.

7. Erzeugnis nach Anspruch 5, wobei die Nitridschicht eine Dicke im Bereich von 5 bis 20 µm aufweist und das Germanium in einem atomaren Anteil zwischen 10 und 15 % in der Nähe von 13 % vorliegt.

8. Verfahren zum Ausbilden einer kristallinen Schicht aus kubischem Siliziumkarbid, **dadurch gekennzeichnet, dass** es darin besteht, die Schicht durch Epitaxie auf einem monokristallinen Substrat aus Silizium-Germanium anwachsen zu lassen, wobei das Germanium in einem atomaren Anteil zwischen 5 und 20 % vorliegt.

9. Verfahren nach Anspruch 8, wobei die Bildung der Schicht aus Siliziumkarbid einen ersten Schritt aufweist, der darin besteht, eine Karburierung der Oberfläche des Substrates in Gegenwart eines Karburierungsgases, das aus der Gruppe ausgewählt ist, die Propan und Ethylen umfasst, und in Gegenwart von Wasserstoff bei einer Temperatur niedriger als 1150°C durchzuführen, und einen zweiten Schritt, nämlich Anwachsen durch chemische Abscheidung aus der Dampfphase aufweist.

10. Verfahren nach Anspruch 9, das weiterhin eine Phase des Anwachsens einer Siliziumschicht mit einer Dicke von 10 bis 50 µm vor dem Karburierungsschritt aufweist.

11. Verfahren nach Anspruch 9, das ferner einen Schritt der Umwandlung von Silizium in flüssiger Phase in Siliziumkarbid aufweist.

12. Verfahren nach Anspruch 8, welches darüber hinaus den Schritt umfasst, das Anwachsen einer Schicht eines Nitrides eines Elementes der Gruppe III auf der Schicht aus Siliziumkarbid zu realisieren.

13. Verfahren zum Bilden einer kristallinen Schicht eines Nitrides eines Elementes der Gruppe III, **dadurch gekennzeichnet, dass** es darin besteht, die Schicht auf einem monokristallinen Substrat aus Silizium-Germanium anwachsen zu lassen, wobei das Germanium in einem atomaren Anteil zwischen 10 und 90 % vorliegt.

## Claims

1. An intermediary product for the forming of optical, electronic, or optoelectronic components, comprising a crystalline cubic silicon carbide layer on a single-crystal substrate, **characterized in that** the substrate is silicon-germanium, the germanium being in an atomic proportion ranging between 5 and 20%.

2. The product of claim 1, wherein the silicon carbide layer has a thickness of about 2 to 3 *µ*m, and wherein the germanium is in an atomic proportion close to 7.5%, between 5 and 10%.

3. The product of claim 1, wherein the silicon carbide layer has a thickness of about 5 to 20 µm, and wherein the germanium is in an atomic proportion close to 16%, between 14 and 18%.

4. The product of claim 1 or 2, wherein the silicon carbide layer is coated with a nitride group III element.

5. An intermediary product for the forming of optical, electronic, or optoelectronic components, comprising a crystal layer of a group III nitride such as AIN, InN, GaN on a (111) oriented single-crystal silicon-germanium substrate, the germanium being in an atomic proportion ranging between 10 and 90%.

6. The product of claim 5, wherein the nitride layer has a thickness of about 1 to 5 µm, and wherein the germanium is in an atomic proportion close to 85%, between 80 and 90%.

7. The product of claim 5, wherein the nitride layer has a thickness of about 5 to 20 µm, and the germanium is in an atomic proportion close to 13%, between 10 and 15%.

8. A method for forming a cubic silicon carbide crystal layer, consisting of growing by epitaxy said layer on a single-crystal silicon-germanium substrate, the germanium being in an atomic proportion ranging between 5 and 20%.

9. The method of claim 8, wherein the forming of the silicon carbide layer comprises a first step consisting of carburizing the substrate surface in the presence of a carburization gas selected from the group comprising propane and ethylene, and in the presence of hydrogen, at a temperature smaller than 1150°C and a second step of chemical vapor deposition.

10. The method of claim 9, further comprising a step of growth of a silicon layer of a thickness of 10 to 50 *µ*m before the carburization step.

11. The method of claim 9, further comprising a step of liquid phase conversion of the silicon into silicon carbide.

12. The method of claim 8, further consisting of growing a layer of a group III nitride on the silicon carbide layer.

13. A method for forming a crystal layer of a nitride of group III element, consisting of growing said layer on a single-crystal silicon-germanium substrate, the germanium being in an atomic proportion ranging between 10 and 90%.
